# EUROPEAN PATENT APPLICATION

(11) **EP 4 201 872 A1**
(43) Date of publication of application: **28.06.2023**
(21) Application number: 21217618.4
(22) Date of filing: 23.12.2021
(51) Int. Cl.: B81C 1/00

(54) **MICROSYSTEM AND MANUFACTURING METHOD**

(71) Applicant: Audio Pixels Ltd., 7670203 Rehovot (IL)
(72) Inventor: LURIE, Dmitri, Rehovot (IL); HOREV, Menachem, Rehovot (IL); COHEN, Yuval, Rehovot (IL); LEWIN, Daniel, Rehovot (IL); MOR CHAIM, Yogev, Rehovot (IL); HALACHMY, Rephael, Rehovot (IL)
(74) Representative: Plasseraud IP

(57) **Abstract**

The present disclosure provides a method for use in manufacturing a microsystem, the method comprising forming an array of pillars in a thickness of a substrate, an area surrounding the array of pillars defining a cavity in the substrate; transforming at least some of the pillars into a sacrificial material; and depositing a sacrificial material layer using a non-conformal deposition process to fill up the cavity while enclosing hollow channels between the pillars of the pillars array, thereby obtaining a cavity filled with an etching facilitator arrangement.

## Description

### TECHNOLOGICAL FIELD

The present disclosure relates to the field of micro-electro-mechanical system (MEMS) manufacturing processes. In particular, the present disclosure relates to a method useful in manufacturing a microsystem, a method of manufacturing a MEMS and a MEMS obtained by said method.

### BACKGROUND

MEMS are commonly employed in a wide range of applications such as automotive, consumer, industrial and medical, as well as many other applications.

MEMS devices typically comprise a MEMS structure made of one or more functional layers (typically Polycrystalline Silicon or Metal) and sacrificial layers (typically Silicon dioxide or organic materials). MEMS structures can be of various types and depend on the intended MEMS function.

During the manufacturing process, the sacrificial layers are selectively removed in a process called "release" (for example: Silicon dioxide is chemically etched away by hydrofluoric acids), leaving the MEMS structure suspended in air so that it is able to perform its intended function.

While an etchant during the release process removes preferentially the sacrificial layers, the etchant can as well damage the functional layers due to a finite selectivity of the sacrificial layers over the functional layers. Therefore, the release time is usually limited, to limit damage to the MEMS functional layers. In order to address this issue, a typical MEMS design with a large MEMS structure element (e.g. superior to 100 µm²) includes apertures through said element with a relatively high density so as to provide several pathways for the etchant to remove the underlying sacrificial layer(s) in a limited time and avoid damaging the functional layers.

MEMS devices with a large MEMS structure element and without apertures or with a low density of apertures are difficult to release and their release may cause damage to the device during a prolonged release process.

There are many MEMS devices that comprise a cavity embedded in a substrate and a functional MEMS structure element (also referred to as mechanical element) suspended above the cavity. The conventional way to create such a cavity is by etching the entire thickness of the substrate from the back to create a through-substrate cavity. In that case, if there is a need to release a sacrificial layer which is located under a non-perforated functional layer, the required release etchant is introduced from the through-substrate cavity i.e. from the backside of the substrate.

While allowing a release of the MEMS structure with large area elements, the through-substrate cavity introduces many processing complications, including front to back alignment of the substrate, a need for flipping the substrate and exposing its front surface where the MEMS device is fabricated to the fabrication machinery, compromising the mechanical integrity of the substrate that may break under the stresses introduced during the fabrication of the MEMS device layers, and design constrains including a lack of control of the cavity depth and width limiting device density.

For example, US 8,580,596 provides a method of forming a microcavity in a micro-electrical mechanical system (MEMS). The method disclosed includes providing a plurality of release openings through a backside of a substrate at the microcavity, etching through the release openings and forming a hermetic sealing layer on the backside of the substrate to seal the microcavity formed by etching.

As explained above, backside processing involves several constraints on the manufacturing process as well as on the resulting MEMS device. Therefore, there is a need in the art for alternative methods useful in MEMS device manufacturing.

### GENERAL DESCRIPTION

The present disclosure relates to a method useful in manufacturing a MEMS device including a MEMS structure having a suspended functional layer (typically made of Polycrystalline Silicon) above a cavity and/or a MEMS structure that requires a suspended functional layer above an air gap.

The present disclosure provides a method for use in manufacturing a microsystem. The method comprises forming an array of pillars in a thickness of a substrate, a volume enclosing the array of pillars defining a cavity in the substrate; transforming at least some of the pillars into a sacrificial material; depositing a sacrificial material layer using a non-conformal deposition process to fill up the cavity while encasing hollow channels between the transformed pillars of the pillars array, thereby obtaining a cavity filled with an etching facilitator arrangement. The step of forming the pillars array may be perfomed using etching processes, for example dry etching processes. The step of transforming at least some of the pillars into a sacrificial material may be performed using an oxidation processing. The step of depositing non-conformally a sacrificial material layer may be followed by a step of withdrawing the sacrificial material using a wet etching processing, thereby making said cavity empty.

In some embodiments, forming the array of pillars in a thickness of a substrate comprises: patterning the substrate to form a mask layer defining an array of features; and etching the patterned substrate around said features to form the pillars array beneath the features array and the cavity surrounding the pillars array, the cavity including a plurality of trenches between the pillars of the pillars array. In other words, the plurality of trenches may form a mesh of trenches. In other words, the shape of the array of features may define a cross-sectional shape of said pillars array in a plane parallel to the substrate surface.

In some embodiment, patterning of the trenches may be performed instead of patterning the features. The trenches may extend across the cavity area to form the outline of the cavity.

In some embodiments, the mask layer may further include a cavity outline and the array of features is within said cavity outline.

In some embodiments, the method may further comprise a step of removing the mask layer before the step of transforming at least some of the pillars into a sacrificial material.

In some embodiments, at least some of the features in the features array have a shape of a stem including at least one arm extending outwards.

In some embodiments, at least some of the features in the features array have a shape of a stem with at least three arms extending outwards.

In some embodiments, transforming at least some of the pillars into a sacrificial material includes fully transforming each pillar of the pillars array into sacrificial material.

In some embodiments, transforming at least some of the pillars into a sacrificial material includes partially transforming one or more pillars of the pillars array into sacrificial material.

In some embodiments, forming an array of pillars in a thickness of a substrate includes forming a plurality of pillar clusters and wherein the cavity comprises a plurality of sub-cavities each enclosing a pillar cluster of the array of pillars.

In some embodiments, at least some of the hollow channels are interconnected and form at least one network of interconnected channels.

In some embodiments, at least some of the hollow channels are interconnected and form several networks of interconnected channels.

In some embodiments, at least one hollow channel is not connected with the other hollow channels.

In some embodiments, the method further comprises (d) flattening of the top surface of the filled cavity filled with the etching facilitator arrangement.

In some embodiments, the substrate is made of silicon, the step of transforming into a sacrificial material includes an oxidation process and the non-conformal sacrificial material layer deposition includes a non-conformal silicon-dioxide layer deposition.

In another aspect, the present disclosure provides a method of manufacturing a micro-electro-mechanical system (MEMS) device comprising at least one suspended MEMS structure. The method comprises: forming a substrate with a cavity filled with an etching facilitator arrangement according to any of the methods described therein and any of their embodiments; forming by micromachining the at least one MEMS structure above the at least one cavity filled with the etching facilitator arrangement, said at least one MEMS structure including one or more pathways therethrough providing access to the etching facilitator arrangement; and etching through said one or more pathways to reach the hollow channels so as to spread an etchant material through the channels and remove the sacrificial material from the filled cavity, thereby suspending the at least one MEMS structure over the (emptied) cavity. In other words, the etchant may spread within the channels of the facilitator arrangement thereby etching the transformed pillars and sacrificial material. This leads to an (at least partially) empty cavity over which the MEMS structure is suspended.

In some embodiments, the method further comprises (IV) depositing one or more additional sacrificial layers to fill the one or more pathways in the MEMS structure. The depositing step may be performed without fully filling the cavity.

In some embodiments, the method further comprises forming a second MEMS structure above said at least one MEMS structure.

In some embodiments, the at least one MEMS structure comprises a plurality of adjacent MEMS structures.

In another aspect, the present disclosure provides a method of manufacturing a micro-electro-mechanical system (MEMS) device comprising at least one suspended MEMS structure. The method comprises: forming a substrate with a cavity filled with a sacrificial material including one or more hollow channels embedded into said sacrificial material; forming by micromachining the at least one MEMS structure above the at least one cavity filled with the sacrificial material, said at least one MEMS structure including one or more pathways therethrough providing access to the filled cavity; and etching through said one or more pathways to reach the hollow channels so as to spread an etchant material therethrough and remove the sacrificial material from the filled cavity, thereby suspending the at least one MEMS structure over the cavity.

In some embodiments, at least some of the one or more hollow channels are interconnected.

In another aspect, the present disclosure provides a micro-electro-mechanical system (MEMS) device obtained by the methods of manufacturing a MEMS device described hereinabove.

In some embodiments, the MEMS device is a sensor or an actuator such as a speaker.

In another aspect, the present disclosure provides a device for use in MEMS manufacturing including: a substrate; a cavity formed in a thickness of the substrate wherein said cavity is filled of sacrificial material, one or more hollow channels being embedded into said sacrificial material.

In some embodiments, at least some of the hollow channels are interconnected.

In some embodiments, the interconnected hollow channels form one or more channel networks.

In some embodiments, the substrate is made of silicon and the sacrificial material is made of silicon dioxide.

In another aspect, the present disclosure provides a device for use in MEMS manufacturing including: a substrate; a cavity formed in a thickness of the substrate wherein said cavity comprises a pillars array made of sacrificial material and wherein a non-conformal sacrificial layer is deposited over the cavity so as to embed one or more hollow channels between the pillars of the pillars array.

In some embodiments, at least some of the hollow channels are interconnected. In some embodiments, the interconnected hollow channels form one or more channel networks.

In some embodiments, the substrate is made of silicon and the sacrificial material is made of silicon dioxide.

In the present application, the following terms and their derivatives may be understood in light of the below explanations:
As used herein, the term "cavity" may refer to a recess i.e. an open cavity. In particular, a substrate cavity may be open on one side only i.e. the cavity may not form a through-hole throughout the substrate thickness or an enclosed cell within the substrate.

As used herein, the term "MEMS" may refer to a micro electro mechanical system (also referred to as microsystems or micromachines). MEMS generally function as transducers. The term "transducer" may refer to an entity/device configured to transform one form of signal or energy into another form and may include both sensors and actuators. The term "sensor" may refer to an entity/device configured to measure information from a surrounding environment and to provide an electrical output signal in response to the parameter it measured. Examples of MEMS sensors may include accelerometers, gyroscopes, inertial measurement units, pressure sensors, temperature sensors, proximity sensor, humidity sensors, microphones, etc. The term "actuator" may refer to a device configured to convert an electrical signal into an action e.g., into a force to manipulate itself, other mechanical devices, or the surrounding environment to perform a predetermined function. Examples of MEMS actuators may include speakers, deflecting mirrors, pumps etc.. A MEMS typically comprises a MEMS structure suspended above a cavity which is formed by sequential processes of, on the one hand, depositing and/or chemically transforming layers for forming both the (functional) layers of the desired MEMS structure and the layers yet to become sacrificial, and, on the other hand, removing the sacrificial layers during the manufacturing process.

As used herein, the term "wafer" may refer to a substrate. Generally, the substrate material is typically silicon, while other substrates may be used. Silicon can be readily oxidized to form a chemically inert and electrically insulating Silicon dioxide (SiO₂) on exposure to oxygen.

As used herein, the term "patterning" may refer to transferring of a master pattern (also referred to as "mask" or "photomask") onto the surface of a substrate or on any process layer added on the substrate. A typical patterning Photolithography Process may involve the application of a light-sensitive photoresist layer followed by photoresist exposure through the mask and then developing the exposed photoresist, leaving a pattern on the wafer surface. In other words, photolithography may involve depositing a photoresist layer of an organic polymer, which is sensitive to ultraviolet radiation, on the substrate. A photomask, consisting of a glass plate (transparent) coated with a chromium pattern (opaque), may then be placed in contact with the photoresist coated surface. The wafer may then be exposed to light (e.g. ultraviolet radiation), thereby transferring the pattern on the mask to the photoresist which is then developed in a way very similar to the process used for developing photographic films. Alternatively, the photoresist may be exposed in a direct-write process using scanning lasers, electron-beams or other radiation sources. The radiation causes a chemical reaction in the exposed areas of the photoresist. There are generally two types of photoresist layer: positive and negative. Positive photoresist is strengthened by the radiation whereas negative photoresists are weakened. Thereafter, on developing, a rinsing solution may remove either the exposed areas (for a negative photoresist layer) or the unexposed areas (for a positive photoresist layer) of photoresist leaving a pattern of bare and photoresist-coated substrate on the wafer surface. In the present disclosure, the patterned photoresist layer may also be referred to as a mask layer. The resulting photoresist pattern is either the positive or negative image of the original pattern of the photomask. Generally, etching may then be performed for example to create trenches below the bare areas. The remaining photoresist may subsequently be removed, e.g. with hot sulfuric acid which attacks the photoresist but not the silicon.

As used herein, the term "feature" may refer to a spot (i.e. a closed plane shape) on a photomask. In particular, a feature array may geometrically form a repetitive pattern of spots of various shapes. In some embodiments, the features array may be spread on the photomask into one or more features clusters. In some embodiments, at least some of the features in the feature array have a shape including a stem and an arm extending outwards. In some embodiments, at least some of the features in the feature array have a shape including a stem and three or more arms extending outwards (i.e. a star-like shape). The Applicant has found that shapes including a stem and at least one arm extending outwards limit the displacement of the resulting pillars due to stress buildup in the following transforming (e.g. oxidation) process. The term "feature" may also be understood as a planar closed configuration.

In some embodiments, photolithography may preliminarily involve covering the substrate with an oxide layer, e.g. silicon dioxide (SiO2), in the case of silicon wafers, on which a pattern of holes is to be formed. These embodiments are generally referred to as "hard masking" embodiments. The rest of the photolithography follows generally the method described above: A photoresist layer of an organic polymer, which is sensitive to radiation, may be deposited on the oxide layer. The photomask may then be placed in contact with the photoresist coated surface. The wafer may then be exposed to the radiation, thereby transferring the pattern on the mask to the photoresist layer. Thereafter, a rinsing solution may remove either the exposed areas (for a negative photoresist layer) or the unexposed areas (for a positive photoresist layer) of photoresist leaving a pattern of bare and photoresist-coated oxides on the oxide layer i.e. forming the mask layer. The resulting photoresist pattern is either the positive or negative image of the original pattern of the photomask. A chemical (e.g. hydrochloric acid) may be used to attack and remove the uncovered oxide from the exposed areas of the photoresist. The remaining photoresist is subsequently removed, e.g. with hot sulfuric acid which attacks the photoresist but not the oxide layer on the silicon, leaving a pattern of oxide on the silicon surface.

As used herein, the term "etching" may refer to a subtractive process that involve removal of part of a material. Etching may be caried out to create grooves of different shapes for example using wet etching or dry etching methods.

Wet etching involves the removal of material through immersion in a liquid bath of a chemical etchant. Etchants can be isotropic or anisotropic. Isotropic etchants etch the material at the same rate in all directions, and consequently may lead to undercutting phenomenon i.e. removing of some material located below the etch masks. Examples of isotropic etchant may include hydrofluoric acids (HF) and nitric acid (HNO₃). Anisotropic etchants etch faster in a preferred direction. An example of anisotropic etchant includes potassium hydroxide (KOH). Structures formed in the substrate by anisotropic etchant may be dependent on the crystal orientation of the substrate.

Dry etching relies on vapor phase or plasma-based methods of etching using suitably reactive gases or vapors usually at high temperatures. Two examples of dry etching method for MEMS manufacturing are reactive ion etching (RIE) and deep reactive ion etching (DRIE). RIE may utilize radio frequency (RF) power to drive the chemical reaction. Energetic ions are accelerated towards the material to be etched within a plasma phase supplying additional energy needed for the reaction; as a result, the etching can occur at much lower temperatures (typically 150° - 250°C, sometimes room temperature) than those usually needed (above 1000°C). RIE is not limited by the crystal planes in the silicon, and as a result, deep trenches and pits, or arbitrary shapes with vertical walls can be etched. An etch rate (generally expressed in microns per minute) may depend on an etching method, an etching temperature, an etchant material and concentration and on the material to be etched. DRIE is similar to RIE with the expectation that the etching is performed in steps or stages and in between these steps, the side-walls of the trench are covered with a protective material that protects the sidewalls from the etching plasma, thus allowing deeper trenches or holes to be etched, compared to RIE.

As used herein, the term "structural layer" refers to a layer deposited on a wafer and made of a structural material (for example Polycrystalline Silicon (also referred to as Poly), silicon nitride or Aluminum) out of which a final structure is made.

As used herein, the term "sacrificial layer" refers to a layer that act as a temporary substance that is needed for the device's building process. Structural material may be a material that can be selectively removed without affecting (i.e. damaging) neighboring structural layers. The sacrificial material is finally etched away to release the final structure. For example, silicon-dioxide can be used as a sacrificial material when the structural material used is Polycrystalline silicon.

In the present disclosure the plane which is parallel to the silicon wafer surface is illustrated and referred to as the XY plane. It may also be called the device plane. The term "horizontal" refers to this plane. The term "vertical" refers to the direction which is perpendicular to the horizontal device plane, and it is indicated as the Z-axis in the figures. The terms "above" and "below" refer to differences in Z-coordinates. The terms "height" and "depth" refer to vertical distances (in the Z-direction), while "width" and "length" refer to horizontal distances (in either the X-direction or the Y-direction). Terms such as "vertical" or "horizontal" do not imply anything about the orientation of the silicon wafer when the MEMS device is manufactured, or when the device is in use. The device and the wafer may be oriented in any suitable direction during usage or manufacturing, for example sideways.

Further, unless specifically defined, the description of a layer being deposited or produced 'on' another layer or substrate, includes the options of said layer being produced or deposited directly on, i.e. in contact with, said other layer or substrate, and said layer being produced on one or a stack of intermediate layers between said layer and said other layer or substrate.

### BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:
**Fig. 1** illustrates a cross sectional view of steps of a first part of a method for manufacturing a MEMS device according to some embodiments of the present disclosure;
**Fig. 2** illustrates a top view the steps illustrated in **Fig. 1****;**
**Fig. 3** illustrates a cross sectional view of some further steps of a method for manufacturing a MEMS device according to embodiments of the present disclosure;
**Fig. 4** illustrates a top view the steps illustrated in **Fig. 3****;**
**Fig. 5** illustrates a cross sectional view of a MEMS device according to other embodiments of the present disclosure;
**Fig. 6** illustrates a step of enclosing hollow channels according to some embodiments of the present disclosure.

### DETAILED DESCRIPTION OF EMBODIMENTS

The present disclosure provides a novel technique for forming a cavity embedded in a substrate such as a silicon wafer. In particular, the cavity in the present disclosure may be efficiently formed in a single wafer layer. In other words, bottom and peripheral walls of the cavity may be formed in a unitary substrate.

Generally, a method for manufacturing a MEMS device (such as transducer, a sensor or an actuator) according to the present disclosure can be split into two parts.

In a first part, a cavity filled with an etching facilitator arrangement is formed within a substrate. The etching facilitator arrangement facilitates subsequent etching for example by allowing for a quicker etching compared to the etching of a cavity of similar dimensions but filled with sacrificial material layer without hollow channels, all other etching parameters being similar. The etching facilitator arrangement may include hollow channels enclosed (encircled) in the sacrificial material. Hollow channels enclosed in the sacrificial material improve spreading of the etchant and vacation of the etching products by significantly increasing the etched surface area. Spreading of the etchant through the hollow channels allows exposing concealed areas of the sacrificial material in the cavity i.e. area which are not directly accessible to the etching material through pathways in a MEMS structure suspended above the cavity. This allows providing a faster etching. The hollow channels may be interconnected. Interconnected hollow channels in the sacrificial material allow spreading of the etchant to other parts of the filled cavity when the etchant reaches a hollow channel. For example, the hollow channels may be formed by depositing a non-conformal (low conformity) sacrificial material layer(s) on an array of pillars made of sacrificial material (or more generally on a set of structures extending vertically within the cavity made of sacrificial material).

In a second part, a MEMS structure is formed above the filled cavity. The MEMS structure includes one or more pathways therethrough in order to allow the etching material to reach the cavity filled with the etching facilitator arrangement. The MEMS structure is formed using micromachining techniques i.e., by addition or subtraction of one or more layers of structural and/or sacrificial materials using photolithography and etching techniques. The filled cavity is etched through said one or more pathways so that an etchant material reaches the hollow channels and spreads therethrough thereby removing the sacrificial material from the filled cavity. This enables suspending the at least one MEMS structure over the cavity.

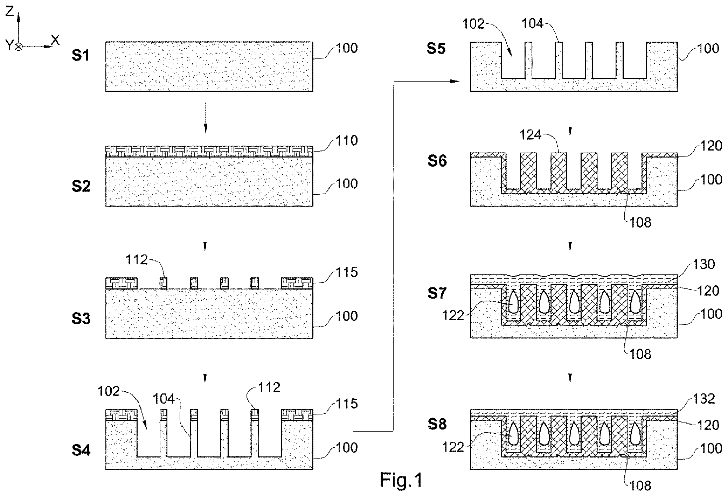

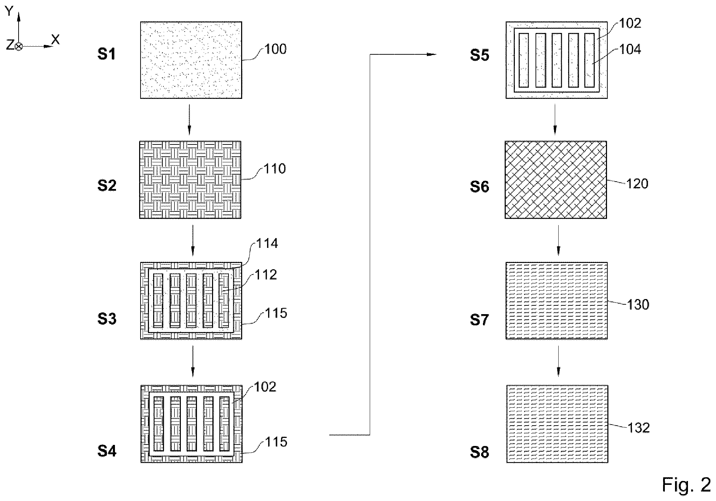

**Fig. 1** and **Fig. 2** respectively illustrate a cross sectional view and a corresponding top view of the steps of an exemplary method for use in micro-electro-mechanical system (MEMS) manufacturing according to some embodiments of the present disclosure. In view of the explanations given hereinabove, **Figs. 1** and **Fig. 2** can be similarly seen as an exemplary first part of a method for manufacturing a micro-electro-mechanical system (MEMS) device comprising at least one suspended MEMS structure according to some embodiments of the present disclosure.

In a first step **S1**, a substrate **100** is provided. - In the present example, the substrate may be made of Silicon. - The substrate may for example be a silicon wafer. It is understood that the present description would also apply to a substrate made of a different material provided oxidation processes are modified to an appropriate method of transforming the substrate material into a sacrificial material and oxide layer deposition processes are modified to an appropriate sacrificial material layer deposition process. For example, the substrate material may be made of an alloy of Ge/GeSi. Ge/GeSi may be oxidized into GeO₂ which can be etched via HBr or water.

In a second step **S2**, a photoresist layer **110** may be deposited on the substrate. The photoresist material may be an organic polymer, which transforms into a soluble material after exposure to radiation.

In a step **S3**, a photomask may then be placed in contact with the photoresist coated surface. The photomask may comprise a transparent plate (e.g. made of glass) coated with an opaque pattern (e.g. made of chromium). The photomask may define a pattern including an array of features. The photomask may include a cavity outline surrounding the array of features. Generally, the features array may geometrically form a repetitive pattern of spots of various shapes. In some embodiments, the features array may be spread on the photomask into one or more features clusters. For example, the features may comprise a pattern including rectangular features and cross shaped features. The wafer **100** may then be exposed to radiation (e.g. ultraviolet light), thereby transferring the photomask pattern on the photoresist layer. After rinsing, the mask layer **115** therefore defines an array of features **112** within a cavity outline **114** (visible on **Fig. 2**). As explained above, in some embodiments, the array of features on the photomask is spread into a plurality of features clusters and the mask layer includes a corresponding plurality of features clusters. The intermediate product obtained at step **S3** i.e., a substrate having a mask layer defining an array of features transferred thereto by using a photomask may be referred to in the present disclosure as a patterned substrate and the process of steps **S1** to **S3** may be referred to altogether as the patterning of the substrate.

Returning to **Figs. 1-2**, in a further step **S4**, etching of the patterned substrate is performed. Preferably, the etching process is a high-ratio non-isotropic silicon etching process such as Deep Reactive Ion Etching (DRIE) process. Because the mask layer **115** defines a protective array of features **112**, etching of the patterned substrate is performed around the features of the array of features **112**. The etching therefore forms at least one cavity embedded in the substrate comprising a mesh of trenches **102** and an array of pillars **104**. The cavity surrounds the array of features **112**. It is understood that in some embodiments in which the array of features on the mask layer comprises a plurality of features clusters, the etching process may cause the formation of a corresponding plurality of cavities surrounding the plurality of features clusters. The mesh of trenches **102** results from etching of the areas of the substrate not protected by the mask layer **115**. The mesh of trenches **102** may form a shared volume of continuous gaps. The pillars array **104** is formed beneath the features array **112** as the irradiated photoresist material of the features array **112** prevents etching of the substrate.

In a further step **S5**, the mask layer **115** is removed from the substrate **100**.

In a further step **S6**, at least some of the pillars of the pillars array **104** are fully oxidized. At least some of the pillars are fully transformed into Silicon Dioxide. As illustrated on **Fig.1**, the substrate **100** may be oxidized until all the pillars are fully oxidized and form an oxidized pillars array **122**. In other words, the furnace oxidation may be a self-limiting process where oxidation continues as long as there is silicon available. In some embodiments, one or more of the pillars are partially oxidized. For example, when the features in the features array have different dimensions, the resulting pillars created by the etching process also have different volumes. Therefore, the oxidation process may be controllably performed until only some of the pillars are fully oxidized. The oxidation process of step **S6** may be a furnace oxidation process such as Atmospheric Pressure Chemical Vapor Deposition or Low Pressure Chemical Vapor Deposition. In the oxidation process of step **S6**, a gas source may only contain Oxygen and the Silicone may be consumed by the oxidation. The furnace oxidation process of step **S6** therefore transforms the pillars array of Silicon into an oxidized pillars array of Silicon Dioxide. As a consequence of the oxidation process, the volume of the oxidized pillars is enlarged in comparison with the pillars array of step **S5**. Furthermore, dents **108** of substrate material may be formed at the feet of the oxidized pillars **124**. Generally, the dents **108** may form protrusions extending from the substrate surface into the oxidized pillars **124**, for example along a central axis of the oxidized pillars **124**.

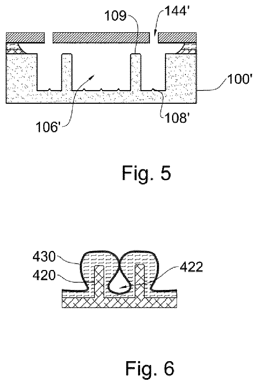

In a further step **S7**, the at least one cavity filled with an etching facilitator arrangement is obtained by depositing one or more low conformal sacrificial oxide layers on the intermediate product originating from step **S6**. Low conformal oxide layers are deposited so as to fill up the at least one cavity while enclosing hollow channels **122** in the mesh (net) of trenches **102** surrounding the oxidized pillars array **124**. Low conformal oxide layers may be deposited for example according to the Plasma Enhanced Chemical Vapor Deposition process using SiH4 and O₂. Low conformal deposition tends to deposit more material at the top of the pillars than at the bottom. **Fig. 6** is a schematic illustration of a low conformal layer deposition process of oxide on an oxidized pillar array **420** represented as oxide layer **430**. As can be seen, the non-conformal layer **430** forms an uneven layer on the pillars **420**. More precisely, the first non-conformal layer **430** causes an accumulation of oxide at a head of the pillars **420**. The accumulation of oxide at the head of the pillars prevents an even deposition of oxide at the feet of the pillars **420** and leads to the creation of a hollow channel **422** between the oxidized pillars **420**. The enclosed grid of the oxidized pillars **124** forms a net of interconnected hollow channels **102**. This improves the spreading of an etchant in a subsequent step described hereinbelow.

In a further optional step **S8**, the surface of the non-conformal oxide layer facing away from the substrate is flattened. Preferably, the flattening may be achieved by a Chemical Mechanical Polishing (CMP) process and does not reach the hollow channels.

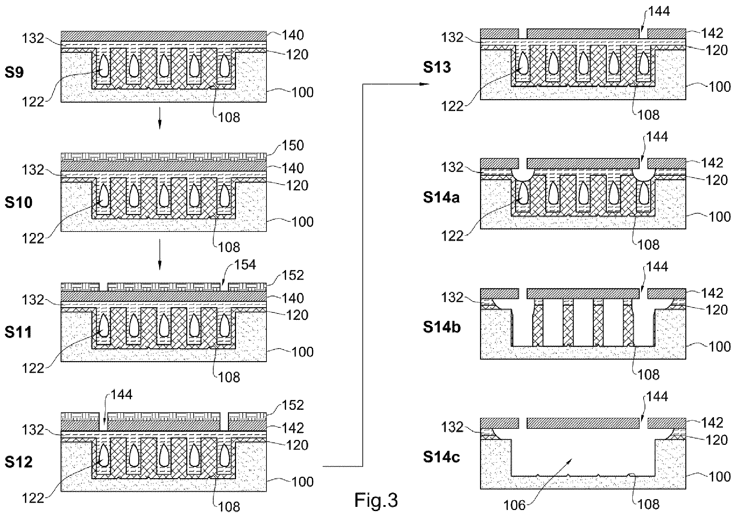

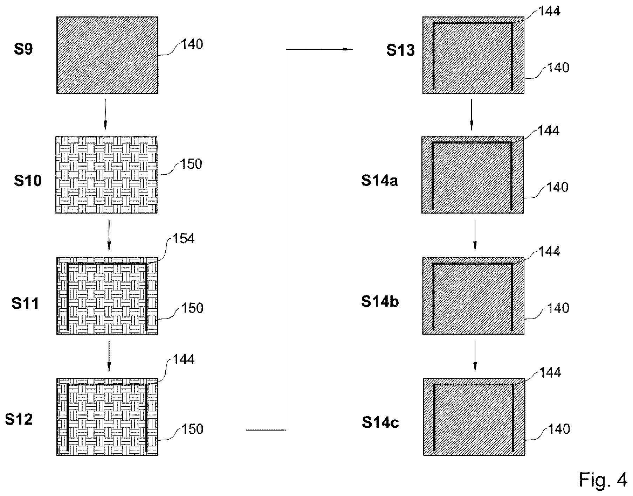

**Fig. 3** and **Fig.4** respectively illustrate a cross sectional view and a corresponding top view of steps of an exemplary second part of a method for manufacturing a micro-electro-mechanical system (MEMS) device comprising at least one suspended MEMS structure according to some embodiments of the present disclosure.

The second part of the method for manufacturing a MEMS device according to the present disclosure may comprise many variations since it encompasses manufacturing of various types of MEMS such as transducers, sensors, actuators of different types.

In the illustrated example, in a step **S9**, a structural layer **140** made of polysilicon is deposited on the intermediate product obtained from step **S8** (i.e. the substrate with a cavity filled with the etching facilitator arrangement made of the oxide pillars array, hollow channels and flattened low conformal oxide layer(s)). The structural layer may form a first plate of the MEMS device.

In a further step **S10**, a photoresist layer **150** may be deposited on the intermediate product resulting from step **S9**. The photoresist material may be an organic polymer, which is sensitive to ultraviolet radiation.

In a further step **S11**, a photomask may then be placed in contact with the photoresist coated surface. The photomask of step **S11** may define one or more pathway features. The pathway features may be configured so that after transfer on the photoresist layer, the pathway features form an opening in the mask layer preferably located above the cavity. The product may then be exposed to radiation, thereby transferring the pathway features on the photoresist layer. After rinsing, the resulting polysilicon layer **140** is patterned with a mask layer **152** defining a pathway feature **154** (i.e. an opening in the mask layer **152** preferably located above the cavity).

In a further step **S12**, etching of the patterned polysilicon layer **140** is performed until the etchant reaches the surface of the flattened low conformal layer **132** facing away from the substrate **100**. Preferably, the etching process is a high-ratio non-isotropic silicon etching process such as Deep Reactive Ion Etching (DRIE) process. Because the mask layer **152** defines a pathway feature **154**, etching of the patterned polysilicon layer **140** is performed down through the pathway feature **154**. The resulting product comprises an etched polysilicon layer **142** defining a pathway **144** replicating a shape of the pathway feature **154** of the mask layer **152** into the polysilicon layer **142**. Generally, the pathway(s) may provide access to the etching facilitator arrangement. In some embodiments, the pathway(s) may be located above the cavity filed with the etching facilitator arrangement.

In a further step **S13**, the mask layer is removed from the etched polysilicon layer **142**.

In a further step **S14a-S14c**, further etching through the pathway **144** of the polysilicon layer **142** is performed. Preferably, the etching process is a high-ratio non-isotropic silicon etching process such as Deep Reactive Ion Etching (DRIE) process, for example using Hydrofluoric (HF) acid as an etchant. Step **S14a-S14c** is illustrated with several drawings for the purpose of showing the evolution of the etching over time rather than referring to different steps involving change of experimental conditions. As illustrated in **S14a**, etching through the pathway **144** of the polysilicon layer **142** creates grooves in the non-conformal oxide layer **132** which reach the hollow channels **122**. The hollow channels **122** expand through the mesh of trenches **102** in between the oxidized pillars array **124**. As explained above, the hollow channels are partially or fully interconnected i.e. there is a hollow route from one hollow channel to another because of the structure of the oxidized pillars array **124**. Therefore, the hollow channels facilitate spreading of the etchant from above the pathway to the whole cavity filled with the etching facilitator arrangement. In fact, when the etchant reaches one hollow channel it can reach all interconnected channels and is therefore in contact with a higher surface of sacrificial material. In other words, the etchant (HF, for example) progresses rapidly through the channels that provide a route for the HF to reach the SiO₂ all over the cavity. As shown in **S14b**, the etchant spreads to the full cavity and the oxidized pillars array gets etched through the hollow channels. **S14c** illustrates the resulting MEMS device including a structural layer **142** (also referred to as a MEMS structure) suspended above the etched cavity **106** embedded in the substrate **100**. Dents **108** remaining from the pillars array **104** may be observed on the bottom wall of the cavity **106**.

Optionally, one or more additional micromachining steps can be performed such as depositing an additional oxide layer to fill the pathway **144**, forming of an additional MEMS structure above the first MEMS structure (i.e. structural layer **142**) or other layer deposition to form a MEMS speaker.

**Fig. 5** shows a cross sectional view of a MEMS device obtained by a manufacturing method according to other embodiments of the MEMS manufacturing method in which some of the pillars of the pillars array are not fully oxidized. For the sake of conciseness, the description of **Fig. 5** focuses on the elements which are differing with regard to previously described embodiments. The elements/steps which are identical or similar to elements/steps previously described are referenced by the same reference followed by an apostrophe (e.g. **100**') and the description given hereinabove with respect to these elements/steps apply similarly. **Fig.** 5 shows a MEMS device including a MEMS structure **142'** including a pathway **144'**. The MEMS structure is suspended over a cavity **106'** embedded in a substrate **100'**. A bottom wall of the cavity **106'** includes fragments of an etching facilitator arrangement used in the manufacturing process of said cavity **106'**. Additionally, the substrate **100'** includes columns **109** which extend vertically from the bottom wall of the cavity. The columns **109** result from embodiments of the process described hereinabove in which the array of features includes features of different dimensions. In these embodiments, after patterning and etching of the substrate, an oxidation step may be performed so that the resulting pillar arrays on the substrate includes fully oxidized pillars and partially oxidized pillars. In these embodiments, after forming of the MEMS structure and pathway and etching of the etching facilitator arrangement, the partially oxidized pillars may form the columns **109**.

The present disclosure enables facilitating fabrication of a MEMS device with a MEMS structure suspended above a cavity wherein the MEMS structure includes one or more pathways and an etching distance in the device plane between a projection of the one or more pathways on the device plane and at least some points of a projection of the cavity on said device plane is superior to 10 microns. In other words, the present disclosure facilitates manufacturing of devices in which an etchant would need to travel in a plane perpendicular to a main etching direction (i.e. the XY plane) for more than about 10 microns away from any of the one or more pathways.

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable sub-combination or as suitable in any other described embodiment of the invention. No feature described in the context of an embodiment is to be considered an essential feature of that embodiment, unless explicitly specified as such.

Although steps of methods according to some embodiments may be described in a specific sequence, methods of the invention may comprise some of the described steps carried out in a different order. A method of the invention may comprise all of the steps described or only a few of the described steps. No particular step in a disclosed method is to be considered an essential step of that method, unless explicitly specified as such.

Although the invention is described in conjunction with specific embodiments thereof, it is evident that numerous alternatives, modifications and variations that are apparent to those skilled in the art may exist. Accordingly, the invention so embraces all such alternatives, modifications and variations that fall within the scope of the appended claims. It is to be understood that the invention is not necessarily limited in its application to the details of construction and the arrangement of the components and/or methods set forth herein. Other embodiments may be practiced, and an embodiment may be carried out in various ways. In particular, in the second part of the method of manufacturing a MEMS comprising at least one suspended MEMS structure, the MEMS structure may be configured for the resulting MEMS to function as a transducer, a sensor or an actuator such as a MEMS speaker. It may include VIAs and interconnections between the layers, a second or further plate, etc. Furthermore, it is noted that some embodiments of the present disclosure may be directed to forming a cavity filled with an etching facilitator arrangement within a thickness of a structural material layer instead of in the substrate itself.

The phraseology and terminology employed herein are for descriptive purpose and should not be regarded as limiting. Citation or identification of any reference in this application shall not be construed as an admission that such reference is available as prior art to the invention. Section headings are used herein to ease for understanding of the specification and should not be construed as necessarily limiting.

## Claims

1. A method for use in manufacturing a microsystem, the method comprising:
**(a)** forming an array of pillars in a thickness of a substrate, a volume enclosing the array of pillars defining a cavity in the substrate;
**(b)** transforming at least some of the pillars into a sacrificial material;
**(c)** depositing a sacrificial material layer using a non-conformal deposition process to fill up the cavity while encasing hollow channels between the transformed pillars of the pillars array, thereby obtaining a cavity filled with an etching facilitator arrangement.

2. The method according to claim 1, wherein forming the array of pillars in a thickness of a substrate comprises:
**i)** patterning the substrate to form a mask layer defining an array of features;
**ii)** etching the patterned substrate around said features to form the pillars array beneath the features array and the cavity surrounding the pillars array, the cavity including a mesh of trenches between the pillars of the pillars array.

3. The method according to claim 2, wherein the mask layer further includes a cavity outline and the array of features is within said cavity outline.

4. The method according to any of the preceding claims, wherein at least some of the features in the features array have a shape of a stem including at least one arm extending outwards.

5. The method according to any of the preceding claims, wherein at least some of the features in the features array have a shape of a stem with at least three arms extending outwards.

6. The method according to any of the preceding claims, wherein transforming at least some of the pillars into a sacrificial material includes fully transforming each pillar of the pillars array into sacrificial material.

7. The method according to any of claims 1-5, wherein transforming at least some of the pillars into a sacrificial material includes partially transforming one or more pillars of the pillars array into sacrificial material.

8. The method according to any of the preceding claims, wherein at least some of the hollow channels are interconnected in at least one network of interconnected channels.

9. The method according to any of claims 1 to 8, wherein at least one hollow channel is not connected with the other hollow channels.

10. The method according to any of the preceding claims, wherein the substrate being made of silicon, the step of transforming into a sacrificial material includes an oxidation process and the non-conformal sacrificial material layer deposition includes a non-conformal silicon-dioxide layer deposition.

11. A method of manufacturing a micro-electro-mechanical system (MEMS) device comprising at least one suspended MEMS structure, the method comprising:
**I.** forming a substrate with a cavity filled with an etching facilitator arrangement according to any of the preceding claims;
**II.** forming by micromachining the at least one MEMS structure above the at least one cavity filled with the etching facilitator arrangement, said at least one MEMS structure including one or more pathways therethrough providing access to the etching facilitator arrangement;
**III.** etching through said one or more pathways to reach the hollow channels so as to spread an etchant material through the channels and remove the sacrificial material from the filled cavity, thereby suspending the at least one MEMS structure over the cavity.

12. The method according to claim 11, further comprising (**IV**) depositing one or more additional sacrificial layers to fill the one or more pathways in the MEMS structure.

13. A micro-electro-mechanical system (MEMS) device obtained by the method according to any of claims 11 to 12.

14. The micro-electro-mechanical system (MEMS) device of claim 13, wherein the MEMS device is a sensor or an actuator such as a speaker.

15. A device for use in MEMS manufacturing including:
**(a)** a substrate;
**(b)** a cavity formed within a thickness of the substrate,
wherein said cavity comprises a pillars array made of sacrificial material, said pillars array having been deposited with a non-conformal layer of sacrificial material to fill said cavity while embedding one or more hollow channels between the pillars of the pillars array.
